# DEMANDE DE BREVET EUROPEEN

(11) **EP 0 798 768 A1**
(43) Date de publication de la demande: **01.10.1997**
(21) Numéro de dépôt: 97400554.8
(22) Date de dépôt: 13.03.1997
(51) Int. Cl.: H01L 21/311, G02B 6/12

(54) **Procédé pour fabriquer un composant optique à substrat de silicium cristallin**

(30) Priorité: 25.03.1996 FR 9603675
(71) Demandeur: ALCATEL N.V., 2288 BH Rijswijk (NL)
(72) Inventeur: Tregoat, Denis, 91190 Gif Sur Yvette (FR); Mallecot, Franck, 92120 Montrouge (FR); Artigue, Claude, 92340 Bourg La Reine (FR); Poingt, Francis, 91310 Longpont-sur-Orge (FR); Brot, Christian, 91310 Leuville Sur Orge (FR)
(74) Mandataire: Fournier, Michel Robert Marie

(57) **Abrégé**

Ce procédé comporte les étapes de
- dépôt d'une couche de silice (6) sur un substrat de silicium cristallin (2), cette couche de silice étant dopée par des éléments dopants, puis,
- traitement de ce substrat.

Selon l'invention, avant le dépôt de la couche de silice dopée, on forme sur le substrat une couche de barrage (30) constituée d'un matériau de barrage s'opposant à une diffusion desdits éléments dopants, ladite couche de silice dopée étant déposée sur cette couche de barrage.

L'invention s'applique notamment au couplage d'une nappe de fibres optiques dans un réseau de communication.

## Description

La présente invention trouve notamment application lorsqu'une nappe de fibres optiques doit être raccordée à un dispositif d'optique intégrée. Un procédé connu pour réaliser un tel raccordement utilise une nappe de guides planaires formés pour cela dans des couches de silice dopées déposées sur un substrat de silicium. Il creuse en même temps dans ce substrat des logements dont les surfaces suivent des plans cristallins de ce substrat et permettent ainsi de positionner avec précision les fibres optiques pour assurer leurs couplages respectifs aux guides planaires. Ce procédé connu sera décrit avec plus de précision dans la suite de la présente description. Il présente l'inconvénient de ne pas permettre la réalisation de bons couplages optiques entre les guides planaires et les fibres optiques lorsqu'on veut déposer les couches de silice par un procédé de dépôt connu et relativement peu coûteux. La présente invention résulte notamment de la découverte de causes de cet inconvénient et elle fournit en conséquence un remède à cet inconvénient. Il apparait cependant que de telles causes peuvent engendrer des inconvénients analogues dans d'autres circonstances et que ce même remède est alors utilisable avec avantage. C'est pourquoi cette invention va d'abord être décrite ci-après de manière plus générale puis dans une application particulière. Elle a tout d'abord pour objet un procédé pour fabriquer un composant à substrat de silicium cristallin. Ce procédé comporte les étapes de:
- dépôt d'une couche de silice sur un substrat de silicium cristallin, cette couche de silice étant dopée par des éléments dopants,
- élimination de cette couche de silice dopée sur une région à traiter de ce substrat, et
- traitement de ce substrat dans cette région à traiter, ce traitement étant tel que la qualité du composant fabriqué est conditionnée par la qualité du réseau cristallin de ce substrat dans cette région. Ce traitement peut être de diverses natures qui seront indiquées plus loin. Quelle que soit la nature de ce traitement, ce procédé est caractérisé par le fait que, avant le dépôt de ladite couche de silice dopée, il comporte une étape de formation sur le substrat d'une couche de barrage constituée d'un matériau de barrage s'opposant à une diffusion desdits éléments dopants, ladite couche de silice dopée étant déposée sur cette couche de barrage à une température élevée telle que celle d'une hydrolyse à la flamme, cette couche de barrage étant éliminée dans ladite région à traiter avant ladite étape de traitement.

De préférence le matériau de barrage est une silice exempte des dits éléments dopants, tout au moins de ceux des éléments dopants de la couche de silice dopée qui pourraient altérer les qualités utiles du substrat. Cette silice est typiquement pure. La couche de barrage est alors avantageusement formée par une oxydation du substrat. Une épaisseur de 400 nm peut être par exemple donnée à cette couche par mise du substrat sous atmosphère d'oxygène à 1350°C pendant 1h. Cette couche pourrait cependant aussi être formée par le procédé connu d'hydrolyse à la flamme dit FHD d'après l'anglais "Flame Hydrolysis Deposition" ou par le procédé également connu de dépôt chimique en phase vapeur assisté par plasma dit PECVD d'après l'anglais "Plasma Enhanced Chemical Vapor Deposition". Au moins un autre matériau de barrage peut être utilisé : le nitrure de silicium.

Cette invention trouve typiquement application dans la fabrication de composants optiques ou électro-optiques, la silice dopée étant utilisée pour guider des ondes lumineuses, le silicium cristallin l'étant pour ses propriétés optiques, électriques, de conduction thermique, ou de facilité de gravure. Elle résulte notamment du fait qu'il a été trouvé que le réseau cristallin du silicium pouvait être gravement perturbé par la diffusion d'éléments dopants qui, dans des procédés de fabrication de composants optiques connus, sont inclus dans une couche de silice déposée sur un substrat de silicium. Elle résulte également du fait que les vitesses de diffusion de tels éléments dopants sont beaucoup plus faibles dans les matériaux de barrage proposés que dans le silicium, par exemple cent fois plus faibles dans le cas de la silice. Ces vitesses croissent avec la température et, pour des éléments dopants usuels, elles ne deviennent importantes qu'au dessus de 1000°C. La présente invention trouve donc application lorsque le substrat portant la couche de silice dopée doit ou peut être porté à une température élevée à un moment où un traitement utile nécessitant de bonnes qualités cristallines du substrat n'a pas encore été effectué.

Elle sera utilement mise en oeuvre dans certains processus industriels où une étape d'un tel traitement d'un substrat de silicium cristallin est empêchée ou seulement rendue inefficace,difficile ou coûteuse lorsque ce substrat a été revêtu d'une couche de silice dopée. Ces processus sont tous ceux dans lesquels la température atteinte lors du dépôt de la silice dopée provoque une diffusion dans le silicium d'éléments dopants provenant de cette couche et dans lesquels cette diffusion provoque à son tour une dégradation des qualités que l'on souhaite exploiter. Les caractéristiques importantes à ce sujet incluent :
- les natures desdits éléments dopants et leurs concentrations souhaitées dans la couche de silice dopée, et
- les températures prévisibles auxquelles ce substrat est soumis et les durées prévisibles pendant lesquelles il est soumis à ces températures, et
- la nature et les modalités du traitement à effectuer.

En ce qui concerne les natures et les concentrations des éléments dopants utiles, on peut citer le bore et le phosphore à des concentrations de l'ordre de un pourcent molaire par rapport à la silice. Ces éléments dopants ont par exemple pour fonction d'abaisser la viscosité de la silice pour permettre d'abaisser sa température de mise en oeuvre ou de modifier l'indice de réfraction de la silice. Cet indice est abaissé d'environ 5.10-⁴ par pourcent molaire dans le cas du bore ou du phosphore.

D'autres éléments dopants pouvant être utilisés dans d'autres fonctions seraient le germanium, le titane, le fluor, le chlore, l'azote etc...

En ce qui concerne les températures prévisibles on peut notamment indiquer que cette invention permet de déposer la couche de silice dopée par le procédé dit FHD. Ce procédé connu présente l'avantage d'être relativement économique, mais l'inconvénient de porter le substrat à une température de 1350°C pendant une heure. Une élévation de température importante pourrait aussi être à prévoir, par exemple dans le cas où le procédé FHD serait remplacé par le procédé dit PECVD.

En ce qui concerne le traitement à effectuer sur le substrat, un traitementtypique est une gravure, ladite région à traiter étant alors une région à graver, et cette gravure est guidée. Un telle gravure est réaisée par une exposition du substrat à un moyen d'attaque que l'on peut appeler "guidé" parce que l'attaque du silicium par ce moyen se fait préférentiellement parallèlement aux plans cristallins de ce substrat, cette attaque étant donc guidée par ces plans. La vitesse d'attaque est alors typiquement beaucoup plus grande parallèlement à un tel plan que perpendiculairement à ce plan. Cette attaque permet d'exposer un ou plusieurs plans cristallins afin d'exploiter le fait que ces plans ont des orientations relatives précisément déterminées.

Selon cette modalité typique la couche de barrage est formée sur une face plane orientée selon un plan cristallin de ce substrat. Après élimination de la couche de silice dopée et de la couche de barrage sur au moins la région à graver de cette face plane, les étapes du traitement de gravure sont les suivantes :
- définition d'un moyen d'attaque guidé propre à attaquer le substrat d'une manière guidée par des plans cristallins de ce substrat,
- mise en place sur cette région à graver d'une couche résistant audit moyen d'attaque guidé et présentant au moins un bord de définition orienté selon une direction cristalline de ce substrat, puis,
- exposition de ladite face plane audit moyen d'attaque guidé pour exposer au moins un plan cristallin de ce substrat à partir dudit bord de définition, ce plan formant un angle dièdre non nul avec cette face. On forme ainsi typiquement, entre deux plans cristallins ainsi exposés, un Vé de positionnement permettant d'orienter avec précision une fibre optique sur un substrat de silicium. Des plans cristallins ainsi exposés pourraient cependant avoir d'autres fonctions, par exemple constituer des miroirs pour réfléchir une lumière infrarouge guidée dans une couche de silice formée sur le substrat.

Dans le cas d'une autre nature du traitement à effectuer sur le substrat on forme sur celui ci des pistes électriquement conductrices, par exemple constituées d'or, pour alimenter un composant actif tel qu'un laser rapporté sur le substrat. La constante diélectrique du matériau du substrat doit alors être homogène et prédéterminable. Or il a été trouvé que cette constante était gravement et irrégulièrement modifiée par la présence d'impuretés perturbant le réseau cristallin. On peut également envisager une utilisation des qualités semiconductrices du silicium cristallin.

Un exemple de mise en oeuvre de la présente invention va être donné ci-après à l'aide des figures schématiques ci-jointes. Lorsqu'un élément apparaît sur plusieurs de ces figures il y est désigné par un même signe de référence. Les résines photosensibles utilisées ne sont pas représentées.

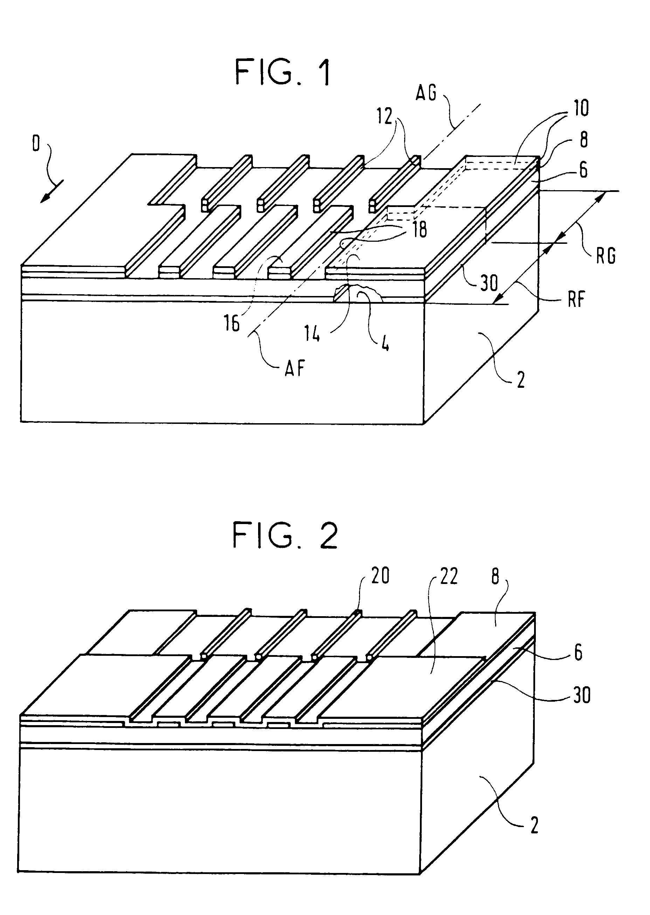

Les figures 1 à 7 représentent des étapes successives du procédé selon l'invention.

La mise en oeuvre donnée en exemple constitue un procédé pour fabriquer un guide planaire à connecter à une fibre optique. Un procédé connu pour cela et précédemment mentionné comporte les étapes qui vont être maintenant indiquées et qui sont utilisées aussi dans le cadre de cette invention :
- Formation d'un substrat 2 constitué de silicium cristallin et présentant une face supérieure 4 orientée selon un plan cristallin de ce substrat, une direction cristalline de ce substrat étant orientée dans ce plan cristallin et constituant une direction longitudinale D, deux régions de cette face supérieure se succédant longitudinalement et constituant respectivement une région de guide RG et une région de fibre RF.
- Dépôt sur la dite face supérieure d'une couche de silice dopée 6 constituant une couche de confinement inférieure et incluant des éléments dopants abaissant l'indice de réfraction de la silice. A titre d'exemple, cette couche a une épaisseur de 0,02 mm, et la silice est dopée par de l'oxyde de bore à une concentration de 10% molaire pour lui donner un indice de réfraction de 1,445 pour une lumière à transmettre ayant une longueur d'onde de 1300 nm.
- Dépôt sur ladite couche de confinement inférieure d'une couche de coeur 8 constituée d'une silice présentant un indice de réfraction supérieur à celui de ladite silice dopée. Cette couche a par exemple une épaisseur de 0,007 mm et est constituée de silice dopée majoritairement de 3% molaires d'oxyde de germanium. Elle présente alors un indice de réfraction de 1,450 pour la lumière à transmettre.
- Dépôt sur la dite couche de coeur d'une couche protectrice complète 10. Cette couche est classiquement constituée de chrome.
- Gravure de la dite couche protectrice complète pour que des parties subsistantes de cette couche constituent une couche protectrice limitée incluant d'une part un ruban de protection de coeur 12 dans ladite région de guide et occupant d'autre part deux bandes de définition de logement 14, 16 dans ladite région de fibre. Le ruban de protection de coeur a un axe longitudinal AG. Les deux bandes de définition de logement définissent entre elles une bande de logement de fibre ayant deux bords longitudinaux tels que 18 constituant deux bords de définition de logement et s'étendant symétriquement de part et d'autre d'un axe AF aligné sur l'axe du ruban de protection de guide. Cette gravure de la couche protectrice de chrome est une photolithogravure classiquement réalisée, de même que d'autres gravures ultérieures, par dépôt d'une résine photosensible, insolation de cette résine à travers un masque d'insolation, développement par lavage sélectif de cette résine pour l'éliminer ou non selon qu'elle a été insolée ou non, puis attaque par un moyen d'attaque tel que les parties subsistantes de cette résine résistent à cette attaque. L'attaque de la couche de chrome est classiquement effectuée à l'aide d'une solution usuelle telle que commercialisée par la firme Shipley sous la marque déposée "Chrome-etchant".

La résine photosensible subsistante n'est pas éliminée tout de suite. La résine utilisée pour cette gravure sera appelée ci-après "première résine".
- Elimination de ladite couche de coeur en dehors de la dite couche protectrice limitée. Le moyen d'attaque de silice utilisée est tel que la première résine photosensible encore en place résiste à ce moyen. L'attaque est limitée pour épargner la couche de confinement inférieure située sous la couche de coeur. On utilise par exemple une gravure ionique réactive assistée par un plasma à basse pression d'un gaz fluoré tel que CHF₃ ou C₂F₆. La situation réalisée par cette gravure est représentée à la figure 1 Cette gravure de la couche de coeur a pour effet de former le coeur 20 du futur guide planaire dans la région de guide, le coeur étant visible à la figure 2.

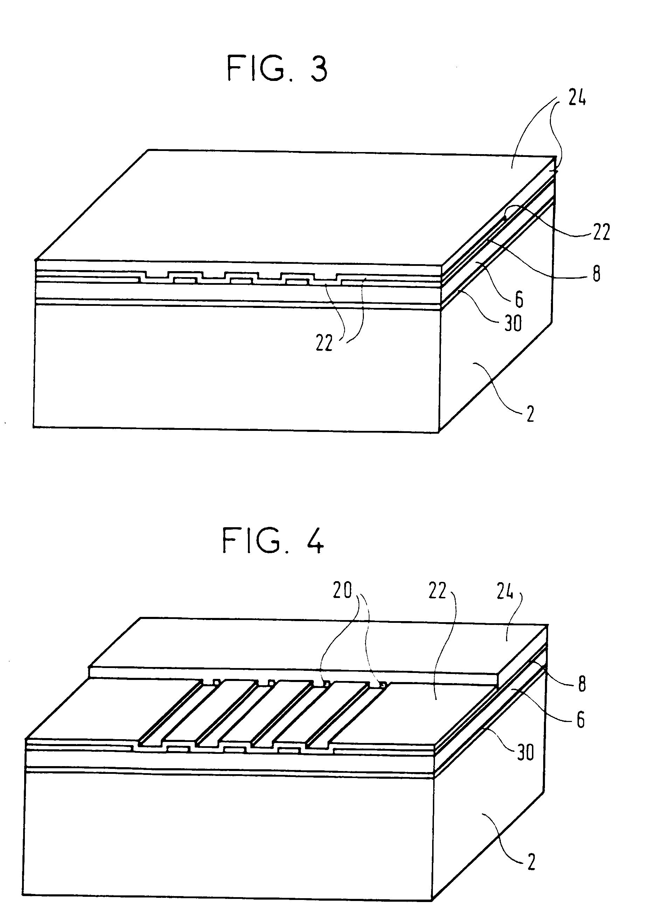

Après cette gravure on élimine complètement la première résine et la couche protectrice.
- Dépôt d'une couche d'arrêt de gravure 22 constituée de silicium et par exemple épaisse de 300 nm.
- Elimination de ladite couche d'arrêt de gravure dans ladite région de guide. Cette élimination est une photolithogravure effectuée à l'aide d'une deuxième résine photosensible que le développement élimine dans la région de guide. La situation réalisée par cette élimination est représentée à la figure 2.
- Dépôt d'une couche de silice dopée constituant une couche de confinement supérieure 24 incluant des éléments dopants abaissant l'indice de réfraction de la silice. Cette couche est déposée tout à fait comme la couche de confinement inférieure. Dans la région de guide, le coeur de guide et les deux couches de confinement inférieure et supérieure constituent le guide planaire qui était à fabriquer. La situation obtenue est représentée à la figure 3.
- Gravure de la couche de confinement supérieure pour l'éliminer dans la région de fibre. Il s'agit là encore d'une photolithogravure. Elle est effectuée à l'aide d'une troisième résine que le développement élimine dans la région de fibre. La gravure est effectuée par ions réactifs RIE et est arrêtée par la couche d'arrêt de gravure. La troisième résine est ensuite complètement éliminée, la situation ainsi obtenue étant représentée à la figure 4.
- Elimination de la couche d'arrêt de gravure par gravure par ions réactifs, cette gravure étant assistée par un plasma d'hexafluorure de soufre SF₆ à basse pression. Cette gravure peut aussi être réalisée par l'action d'une solution diluée de potasse KOH pendant une minute environ.
- Dépôt et développement d'une quatrième résine pour protéger la région de guide.
- Attaque limitée de la silice dans la région de fibre. Le moyen d'attaque utilisée est anisotrope c'est à dire que l'attaque se fait selon la direction verticale. Le moyen d'attaque utilisé est par exemple une gravure par ions réactifs.

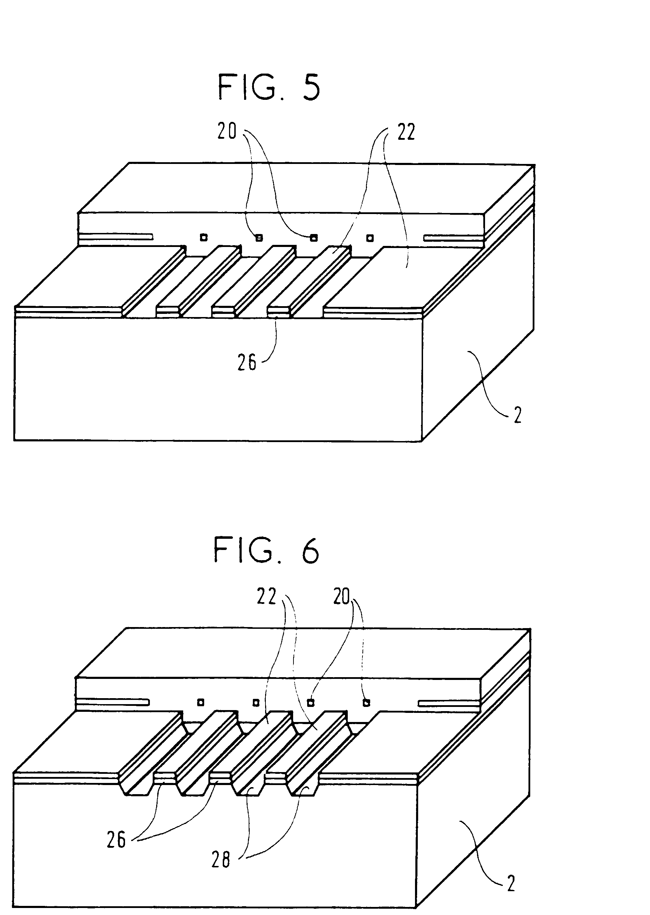

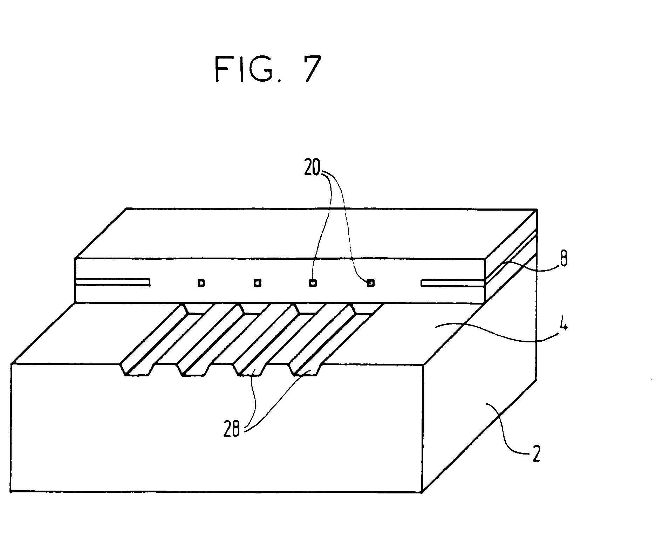

L'attaque est arrêtée lorsque le substrat de silicium est exposé dans ladite bande de logement. Une couche de silice 26 subsiste donc dans les bandes de définition de logement. La situation obtenue est représentée à la figure 5.
- Gravure du substrat par un moyen d'attaque guidé par des plans cristallins de ce substrat. Cette gravure a pour but de creuser un logement 28 pour une fibre optique dans la dite bande de logement en donnant à ce logement deux flancs constitués respectivement par deux plans cristallins du substrat. Ces plans passent par les deux dits bords de définition de logement. La couche de silice 26 subsistant dans les bandes de défnition de logement résiste à ce moyen d'attaque guidé. Le logement réalisé présente typiquement une section transversale en forme de Vé tronqué et constitue un Vé de positionnement tel que précédemment défini. La fibre optique qu'il permet de positionner est alignée avec le guide planaire dans un plan horizontal par le fait que le masque d'insolation utilisé lors de la gravure de la couche protectrice a défini deux axes alignés avec précision, l'un pour le ruban de protection de coeur et l'autre pour la bande de logement de fibre. Selon la direction verticale une position correcte de la fibre est obtenue grâce une correspondance convenable entre l'épaisseur de la couche de confinement inférieure et la largeur de la bande logement de fibre. Un bon couplage peut donc être obtenu entre la fibre optique ainsi positionnée et le guide planaire. Cette gravure du substrat est classiquement effectuée à l'aide d'une solution de potasse à une concentration de 190g par litre dans l'eau pendant 1h 1/2 à une température de 75°C. La situation réalisée par cette gravure est représentée à la figure 6.
- Elimination totale de la silice dans la région de fibre.
- Enfin élimination totale de la quatrième résine, la situation obtenue étant représentée à la figure 7.

En pratique on forme simultanément, sur la même face supérieure d'un substrat, plusieurs guides planaires et plusieurs logements pour une nappe constituée de plusieurs fibres à raccorder respectivement à ces guides. La plupart des bandes de délimitation de logement sont alors chacune commune à deux logements adjacents et située entre ces deux logements.

La qualité du couplage optique obtenu à la suite d'une mise en oeuvre du procédé de fabrication connu qui vient d'être décrit n'est pas toujours bonne. Il a été trouvé qu'elle dépendait du procédé de dépôt utilisé pour former la couche de silice, à savoir les deux couches de confinement et la couche de coeur. Parmi les procédés connus pour un tel dépôt le dépôt chimique en phase vapeur assisté par plasma dit PECVD présente l'inconvénient que sa mise en oeuvre est plus coûteuse que celle du procédé de dépôt par hydrolyse à la flamme dit FHD. Le procédé dit PECVD était cependant connu comme préférable parce que l'expérience avait montré que le couplage optique obtenu n'était bon qu'avec l'utilisation de ce procédé PECVD. Conformément à la présente invention il a été trouvé que les défauts de couplage optique qui avaient été montrés par l'expérience après utilisation du procédé FHD étaient liés aux températures relativement élevées impliquées par ce procédé (1350°C), et aux éléments dopants tels que le phosphore et le bore inclus dans la couche de confinement inférieure. Il a été plus précisément trouvé que ces défauts résultaient du fait que les éléments dopants diffusaient à chaud si rapidement dans le silicium qu'ils venaient perturber gravement le réseau cristallin de ce dernier au voisinage de la face supérieure du substrat. Ils empêchaient alors l'étape de gravure du substrat d'exposer les plans cristallins convenables.

La présente invention a notamment pour but de rendre l'utilisation du procédé de dépôt de silice dit FHD compatible avec un bon couplage optique. Selon cette invention, avant ladite étape de dépôt de la couche de confinement inférieure, on forme sur la dite face supérieure une couche de barrage 30 s'opposant à une diffusion des dits éléments dopants. L'épaisseur de cette couche semble devoir être comprise entre 100 et 2000 nm, et de préférence entre 200 et 1000 nm. La manière dont une telle couche de barrage peut être formée a été précédemment décrite. Il s'agit par exemple d'une couche de silice pure formée par oxydation et épaisse de 400 nm. Les autres couches de silice sont alors formées sans inconvénient par le procédé dit FHD.

## Revendications

1. Procédé pour fabriquer un composant à substrat de silicium cristallin,ce procédé comportant les étapes de :
- dépôt d'une couche de silice sur un substrat de silicium cristallin, cette couche de silice étant dopée par des éléments dopants,
- élimination de cette couche de silice dopée (6) sur une région à traiter (RF) de ce substrat, et
- traitement de ce substrat dans cette région à traiter, ce traitement étant tel que la qualité du composant fabriqué est conditionnée par la qualité du réseau cristallin de ce substrat dans cette région,
ce procédé étant caractérisé par le fait que, avant le dépôt de ladite couche de silice(6) dopée, il comporte une étape de formation sur le substrat (2) d'une couche de barrage (30) constituée d'un matériau de barrage s'opposant à une diffusion desdits éléments dopants, ladite couche de silice dopée étant déposée sur cette couche de barrage à une température élevée telle que celle d'une hydrolyse à la flamme, cette couche de barrage étant éliminée dans ladite région à traiter avant ladite étape de traitement.

2. Procédé selon la revendication 1, ledit matériau de barrage étant une silice exempte desdits éléments dopants.

3. Procédé selon la revendication 2, ladite couche de barrage (30) étant formé par oxydation dudit substrat.

4. Procédé selon la revendication 2, ledit matériau de barrage étant le nitrure de silicium.

5. Procédé selon la revendication 1, l'épaisseur de ladite couche de barrage étant comprise entre 100 et 2000nm, et de préférence entre 200 et 1000nm.

6. Procédé selon la revendication 1, ladite couche de barrage (30) étant formée sur une face plane orientée (4) selon un plan cristallin dudit substrat (2), ladite région à traiter étant une région à graver, ladite étape de traitement de ce substrat comportant elle même les étapes de:
- définition d'un moyen d'attaque guidé propre à attaquer ce substrat d'une manière guidée par des plans cristallins de ce substrat,
- mise en place sur cette région à graver d'une couche (26) résistant audit moyen d'attaque guidé et présentant au moins un bord de définition (18) orienté selon une direction cristalline de ce substrat, puis
- exposition de ladite face plane (4) audit moyen d'attaque guidé pour exposer au moins un plan cristallin de ce substrat à partir dudit bord de définition, ce plan formant un angle dièdre non nul avec cette face.

7. Procédé selon la revendication 1, le dit composant à fabriquer comportant un guide planaire à connecter à une fibre optique, ce procédé comportant les étapes de :
- formation d'undit substrat (2) constitué de silicium cristallin et présentant une face supérieure (4) orientée selon un plan cristallin de ce substrat, une direction cristalline de ce substrat étant orientée dans ce plan cristallin et constituant une direction longitudinale (D), deux régions de cette face supérieure se sucédant longitudinalement et constituant respectivement une région de guide (RG) et une région de fibre (RF),
- dépôt sur ladite face supérieure de ladite couche de barrage (30) et d'une dite couche de silice dopée (6) constituant une couche de confinement inférieure et incluant desdits éléments dopants abaissant l'indice de réfraction de la silice,
- dépôt sur ladite couche de confinement inférieure d'une couche de coeur (8) constituée d'une silice présentant un indice de réfraction supérieur à celui de ladite silice dopée,
- dépôt sur ladite couche de coeur d'une couche protectrice complète (10),
- gravure de ladite couche protectrice complète pour que des parties subsistantes de cette couche constituent une couche protectrice limitée incluant d'une part un ruban de protection de coeur (12) dans ladite région de guide et occupant d'autre part deux bandes de définition de logement (14, 16) dans ladite région de fibre, le ruban de protection de coeur ayant un axe longitudinal (AG), ces deux bandes de définition de logement définissant entre elles une bande de logement de fibre ayant deux bords longitudinaux (18) constituant deux bords de définition de logement et s'étendant symétriquement de part et d'autre d'un axe (AF) aligné sur ledit axe du ruban de protection de guide, cette bande de logement constituant ladite région à graver,
- élimination de ladite couche de coeur en dehors de ladite couche protectrice limitée pour former un coeur (20) définissant ledit guide planaire,
- élimination de ladite couche protectrice limitée,
- dépôt d'une couche d'arrêt de gravure (22),
- élimination de ladite couche d'arrêt de gravure dans ladite région de guide,
- dépôt d'une couche de silice dopée constituant une couche de confinement supérieure (24) incluant des éléments dopants abaissant l'indice de réfraction de la silice,
- gravure de ladite couche de confinement supérieure pour l'éliminer dans ladite région de fibre,
- élimination de ladite couche d'arrêt de gravure,
- attaque limitée de la silice dans ladite région de fibre, pour exposer ledit substrat de silicium dans ladite bande de logement sans attaquer ce substrat et tout en laissant une couche de silice (26) subsister dans lesdites bandes de définition de logement, et
- gravure du substrat par ledit moyen d'attaque guidé par des plans cristallins de ce substrat pour creuser un logement (28) pour une fibre optique dans la dite bande de logement en donnant à ce logement deux flancs constitués respectivement par deux plans cristallins du substrat passant par les deux dits bords de définition de logement, ce procédé étant caractérisé par le fait qu'il comporte, avant ladite étape de dépôt de la couche de confinement inférieure, une étape de formation sur ladite face supérieure d'une couche de barrage s'opposant à une diffusion desdits éléments dopants.

8. Procédé selon la revendication 7, pour fabriquer simultanément sur ladite face supérieure (4) du substrat (2) plusieurs dits guides planaires (20) et plusieurs dits logements (28) pour plusieurs fibres à raccorder respectivemnt à ces guides.
